# EUROPEAN PATENT APPLICATION

(11) **EP 4 560 853 A1**
(43) Date of publication of application: **28.05.2025**
(21) Application number: 24213801.4
(22) Date of filing: 19.11.2024
(51) Int. Cl.: H01S 5/32, H01S 5/20

(54) **LIGHT-EMITTING ELEMENT**

(30) Priority: 21.11.2023 JP 2023197170; 27.06.2024 JP 2024104434
(71) Applicant: Nichia Corporation, Anan-shi, Tokushima 774-8601 (JP)
(72) Inventor: NAGAO, Yoji, Anan-shi, 774-8601 (JP)
(74) Representative: Betten & Resch

(57) **Abstract**

A light-emitting element includes: a first semiconductor layer, a second semiconductor layer, a third semiconductor layer, and a fourth semiconductor layer in this order. The first semiconductor layer is Alₓ₁In_{y1}Ga_{1-x1-y1}N (0 ≤ x1 ≤ 1, 0 ≤ y1 ≤ 1, 0 ≤ x1 + y1 ≤ 1), the second semiconductor layer is Alₓ₂In_{y2}Ga_{1-x2-y2}N (0 ≤ x2 ≤ 1, 0 ≤ y2 ≤ 1, 0 ≤ x2 + y2 ≤ 1), the third semiconductor layer is Alₓ₃In_{y3}Ga_{1-x3-y3}N (0 ≤ x3 ≤ 1, 0 ≤ y3 ≤ 1, 0 ≤ x3 + y3 ≤ 1), and the fourth semiconductor layer is Alₓ₄In_{y4}Ga_{1-x4-y4}N (0 ≤ x4 ≤ 1, 0 ≤ y4 ≤ 1, 0 ≤ x4 + y4 ≤ 1).

## Description

### CROSS-REFERENCE TO RELATED APPLICATIONS

This application claims priority to Japanese Patent Application No. 2023-197170, filed on November 21, 2023, and Japanese Patent Application No. 2024-104434, filed on June 27, 2024, the entire contents of which are incorporated herein by reference.

### BACKGROUND

The present disclosure relates to a light-emitting element.

A laser element using a nitride semiconductor is used for a high-output vehicle-mounted headlight or a light source for a laser processing machine. To efficiently operate a high-output laser element, it is important to increase the carrier injection efficiency of the laser element. One of the factors that reduce the carrier injection efficiency is a phenomenon in which electrons injected into the active layer are thermally excited and overflow into the p-side semiconductor layer. To suppress the overflow of electrons to the p-side semiconductor layer, an electron blocking layer having a band gap larger than that of the p-side semiconductor layer is inserted between the active layer and the p-side semiconductor layer.

A known configuration has a peak of an aluminum (Al) composition ratio in a region of the electron blocking layer close to the active layer (e.g., see Japanese Patent Publication No. 2023-010171 A).

### SUMMARY

The present disclosure provides a light-emitting element with improved carrier injection efficiency.

In one embodiment, a light-emitting element includes a first semiconductor layer, a second semiconductor layer, a third semiconductor layer, and a fourth semiconductor layer in this order, in which the first semiconductor layer is Alₓ₁In_{y1}Ga_{1-x1-y1}N (0 ≤ x1 ≤ 1, 0 ≤ y1 ≤ 1, 0 ≤ x1 + y1 ≤ 1), the second semiconductor layer is Alₓ₂In_{y2}Ga_{1-x2-y2}N (0 ≤ x2 ≤ 1, 0 ≤ y2 ≤ 1, 0 ≤ x2 + y2 ≤ 1), the third semiconductor layer is Alₓ₃In_{y3}Ga_{1-x3-y3}N (0 ≤ x3 ≤ 1, 0 ≤ y3 ≤ 1, 0 ≤ x3 + y3 ≤ 1), and the fourth semiconductor layer is Alₓ₄In_{y4}Ga_{1-x4-y4}N (0 ≤ x4 ≤ 1, 0 ≤ y4 ≤ 1, 0 ≤ x4 + y4 ≤ 1), the second semiconductor layer and the third semiconductor contain a p-type impurity,
the second semiconductor layer has a thickness less than a thickness of the third semiconductor layer, the second semiconductor layer has an Al composition ratio x2 greater than any of an Al composition ratio x1 of the first semiconductor layer, an Al composition ratio x3 of the third semiconductor layer, and an Al composition ratio x4 of the fourth semiconductor layer, and the Al composition ratio x3 of the third semiconductor layer is greater than the Al composition ratio x1 of the first semiconductor layer and the Al composition ratio x4 of the fourth semiconductor layer.

According to certain embodiments, a light-emitting element with improved carrier injection efficiency is realized.

### BRIEF DESCRIPTION OF THE DRAWINGS

FIG. 1 is a schematic cross-sectional view of a light-emitting element.
FIG. 2 is a schematic diagram illustrating a distribution of an Al composition ratio from a first semiconductor layer to a fourth semiconductor layer of the light-emitting element according to an embodiment.
FIG. 3 is a high-angle annular dark field scanning transmission electron microscope (HAADF-STEM) image of a fabricated light-emitting element.
FIG. 4 is a graph showing the Al composition ratio from the first semiconductor layer to the fourth semiconductor layer.
FIG. 5 is a schematic diagram illustrating, as a comparative example, a configuration example in which a peak of the Al composition ratio is present in a region far from an active layer of an electron blocking layer.
FIG. 6 is a graph showing slope efficiency with respect to the current for the light-emitting elements of the example and the comparative example.

### DETAILED DESCRIPTION

Hereinafter, embodiments of the present disclosure are described with reference to the drawings. The following description is intended to embody technical concepts of the present disclosure, and the present invention is not limited to the described embodiments unless specifically stated. In each drawing, members having identical functions may be denoted by the same reference characters. In view of the ease of explanation or understanding of the points, the embodiments may be illustrated separately for convenience, but the partial substitutions or combinations of the configurations illustrated in different embodiments and examples are possible. In the embodiments described below, differences from previous embodiments will be mainly described, and redundant descriptions of commonalities with the previously described embodiments are sometimes omitted. The size, positional relationship, and other features of members illustrated in the drawings may be exaggerated for clarity.

### Embodiments

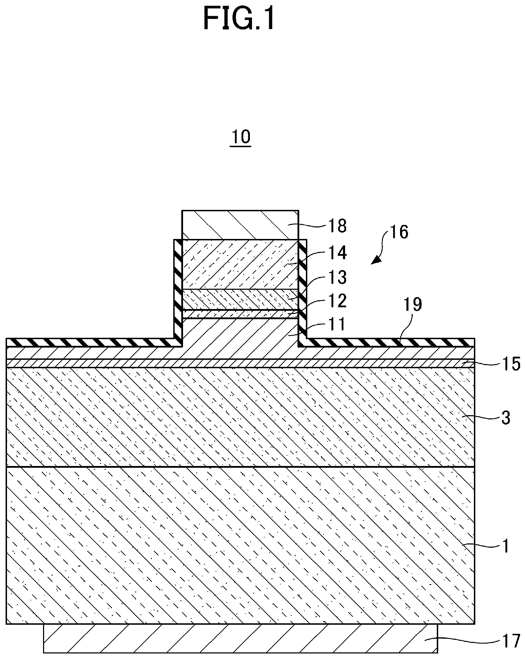

FIG. 1 is a schematic cross-sectional view of a light-emitting element according to an embodiment. The light-emitting element is, for example, a semiconductor laser element. Also, the light-emitting element is, for example, a laser diode. A semiconductor laser element 10 will be described below as an example of the light-emitting element. A cross section illustrated in FIG. 1 is a cross section orthogonal to the resonance direction of the semiconductor laser element 10. The semiconductor laser element 10 includes a substrate 1, an n-side semiconductor layer 3 provided on the substrate 1, and an active layer 15, a first semiconductor layer 11, a second semiconductor layer 12, a third semiconductor layer 13, and a fourth semiconductor layer 14 are provided in this order on the n-side semiconductor layer 3. The first semiconductor layer 11 is located on the side opposite to the n-side semiconductor layer 3 via the active layer 15, and is made of, for example, GaN or AlGaN. The second semiconductor layer 12 is located between the first semiconductor layer 11 and the third semiconductor layer 13, and is a high Al composition layer having the highest Al composition ratio among the first semiconductor layer 11 and the semiconductor layer 14. The third semiconductor layer 13 has an Al composition ratio higher than that of the fourth semiconductor layer 14 and can be used as, for example, an electron blocking layer with respect to the fourth semiconductor layer 14. In this case, at least a portion of the second semiconductor layer 12 may be included in the electron blocking layer. The fourth semiconductor layer 14 is a layer closest to a p-side contact layer side, and can be, for example, a p-side optical guide layer. The second semiconductor layer 12 and the third semiconductor layer 13 provided between the first semiconductor layer 11 and the fourth semiconductor layer 14 have a greater band gap energy than the first semiconductor layer 11 and the fourth semiconductor layer 14, and form a barrier against electrons at the lower end of the conduction band.

The semiconductor laser element 10 is made of a nitride semiconductor. The first semiconductor layer 11 is Alₓ₁In_{y1}Ga_{1-x1-y1}N (0 ≤ x1 ≤ 1, 0 ≤ y1 ≤ 1, 0 ≤ x1 + y1 ≤ 1). The second semiconductor layer 12 is Alₓ₂In_{y2}Ga_{1-x2-y2}N (0 ≤ x2 ≤ 1, 0 ≤ y2 ≤ 1, 0 ≤ x2 + y2 ≤ 1). The third semiconductor layer 13 is Alₓ₃In_{y3}Ga_{1-x3-y3}N (0 ≤ x3 ≤ 1, 0 ≤ y3 ≤ 1, 0 ≤ x3 + y3 ≤ 1). The fourth semiconductor layer 14 is Alₓ₄In_{y4}Ga_{1-x4-y4}N (0 ≤ x4 ≤ 1, 0 ≤ y4 ≤ 1, 0 ≤ x4 + y4 ≤ 1). The second semiconductor layer 12 and the third semiconductor layer 13 contain a p-type impurity. The second semiconductor layer 12 has a thickness less than a thickness of the third semiconductor layer 13. The second semiconductor layer 12 has an Al composition ratio x2 greater than any of an Al composition ratio x1 of the first semiconductor layer 11, an Al composition ratio x3 of the third semiconductor layer 13, and an Al composition ratio x4 of the fourth semiconductor layer 14. The Al composition ratio x3 of the third semiconductor layer 13 is greater than the Al composition ratio x1 of the first semiconductor layer 11 and the Al composition ratio x4 of the fourth semiconductor layer 14.

In the first embodiment, a GaN substrate is used as the substrate 1. A+c (0001) plane of the GaN substrate is used as a primary plane, and the first semiconductor layer 11, the second semiconductor layer 12, the third semiconductor layer 13, and the fourth semiconductor layer 14 are grown on the +c plane. Here, the term "the +c-plane as the primary plane" includes an offset within ± 1 degree. The use of the substrate having the +c-plane as the primary plane improves productivity. An n-side electrode 17 is provided on the back surface of the substrate 1. The substrate 1 may be doped with an n-type impurity to make it function as a contact layer.

The n-side semiconductor layer 3 and the active layer 15 are disposed between the substrate 1 and the first semiconductor layer 11. The n-side semiconductor layer 3 is made of AlGaN, and a binary, ternary, or quaternary nitride semiconductor can be used. The n-side semiconductor layer 3 includes one or more types of n-side semiconductor layers, and may include, for example, an n-side cladding layer and an n-side optical guide layer. The n-side cladding layer has a band gap energy larger than that of the n-side optical guide layer. To suppress light absorption, the n-side optical guide layer is preferably undoped or has an n-type impurity concentration lower than that of the n-side cladding layer. Here, "undoped" means that a film is formed without intentional addition of impurities, and means that the impurity concentration is 1 × 10¹⁶ cm⁻³ or less, or that the film does not substantially contain impurities.

An optical confinement layer of undoped AlInGaN may be provided in the interface region between the n-side semiconductor layer 3 and the active layer 15, that is, in the uppermost layer of the n-side semiconductor layer 3. To effectively confine light in the active layer in the layering direction, an In composition ratio y1 of the undoped optical confinement layer is preferably less than 0.05.

### First Semiconductor Layer 11

The first semiconductor layer 11 is provided between the active layer 15 and the second semiconductor layer 12 which is a part of the p-side semiconductor layer, and is made of Alₓ₁In_{y1}Ga_{1-x1-y1}N (0 ≤ x1 ≤ 1, 0 ≤ y1 ≤ 1, 0 ≤ x1 + y1 ≤ 1). The first semiconductor layer 11 is provided, for example, for the purpose of confining light in the active layer 15. The first semiconductor layer 11 is formed, for example, in an undoped state. The composition ratios x1 and y1 are determined so as to enable effective confinement of light in the active layer 15. The In composition ratio y1 of the first semiconductor layer 11 may be zero. In this case, the refractive index of the first semiconductor layer 11 decreases, and the light blocking performance can be enhanced.

The uppermost layer of the first semiconductor layer 11 may be a barrier layer or a well layer. From the viewpoint of suppressing overflow of electrons to the fourth semiconductor layer 14 which is close to the p-side contact layer and promoting diffusion of holes to the active layer 15, the uppermost layer of the first semiconductor layer 11 may be a well layer.

### Second Semiconductor Layer 12 and Third Semiconductor Layer 13

The second semiconductor layer 12 and the third semiconductor layer 13 are provided between the first semiconductor layer 11 and the fourth semiconductor layer. The second semiconductor layer 12 is provided closer to the n-side semiconductor layer 3 than the third semiconductor layer 13, and is made of Alₓ₂In_{y2}Ga_{1-x2-y2}N (0 ≤ x2 ≤ 1, 0 ≤ y2 ≤ 1, 0 ≤ x2 + y2 ≤ 1). The third semiconductor layer 13 is provided closer to the fourth semiconductor layer 14 than the second semiconductor layer 12, and is made of Alₓ₃In_{y3}Ga_{1-x3-y3}N (0 ≤ x3 ≤ 1, 0 ≤ y3 ≤ 1, 0 ≤ x3 + y3 ≤ 1). The second semiconductor layer 12 and the third semiconductor layer 13 may be used as electron blocking layers. The second semiconductor layer 12 has the Al composition ratio x2 greater than any of an Al composition ratio x1 of the first semiconductor layer 11, an Al composition ratio x3 of the third semiconductor layer 13, and an Al composition ratio x4 of the fourth semiconductor layer 14. The thickness of the second semiconductor layer 12 is less than the thickness of the third semiconductor layer 13. By reducing the thickness of the second semiconductor layer 12, which has a relatively high Al composition ratio, the activation energy of the p-type impurity in the second semiconductor layer 12 is reduced and the hole concentration can be improved. In addition, the second semiconductor layer 12 and the third semiconductor layer 13 can reduce the overflow of electrons and enhance the carrier injection efficiency. An In composition ratio y2 of the second semiconductor layer 12 may be zero. In this case, the refractive index of the second semiconductor layer 12 decreases, and the optical confinement performance can be enhanced. An In composition ratio y3 of the third semiconductor layer 13 may be zero. In this case, the refractive index of the third semiconductor layer 13 decreases, and the light confinement performance can be enhanced.

The thickness of the second semiconductor layer 12 is, for example, greater than 0.5 nm and 2.5 nm or less. By making the second semiconductor layer 12 thicker than 0.5 nm, the overflow of electrons can be effectively reduced. In addition, by making the thickness of the second semiconductor layer 12 2.5 nm or less, the increase in operating voltage can be reduced. A total thickness of the second semiconductor layer 12 and the third semiconductor layer 13 is, for example, greater than 5 nm and 30 nm or less. Making the total thickness of the second semiconductor layer 12 and the third semiconductor layer 13 greater than 5 nm can reduce the possibility of diffusion of the p-type impurity doped in the fourth semiconductor layer 14 into the active layer 15. Making the total thickness of the second semiconductor layer 12 and the third semiconductor layer 13 30 nm or less, the movement of holes in the third semiconductor layer 13 or the second semiconductor layer 12 is less likely to be inhibited, and the increase in forward voltage can be reduced. A p-type impurity such as Mg may be added to the third semiconductor layer 13. In this case, the p-type impurity concentration in the third semiconductor layer 13 is lower than the p-type impurity concentration in the fourth semiconductor layer 14 located close to the p-side contact layer. Adding the p-type impurity to the third semiconductor layer 13 can increase the hole injection efficiency from the fourth semiconductor layer 14 to the first semiconductor layer 11. Since the p-type impurity concentration of the third semiconductor layer 13 is lower than the p-type impurity concentration of the fourth semiconductor layer 14 located close to the p-side contact layer, the optical loss in the third semiconductor layer 13 can be reduced.

Even when the second semiconductor layer 12 is formed in the undoped state, the p-type impurity (e.g., Mg) may be diffused from the third semiconductor layer 13 to the second semiconductor layer 12. When the Al composition ratio x2 of the second semiconductor layer 12 is increased to reduce the overflow of electrons from the first semiconductor layer 11 to the fourth semiconductor layer 14 located on the p-side, it is likely that the activation of the p-type impurity decreases and the series resistance increases. Therefore, when the second semiconductor layer 12 having a large Al composition ratio x2 is thick enough not to reduce the activation of the p-type impurity, the injection of holes from the fourth semiconductor layer 14 to the first semiconductor layer 11 and further to the active layer 15 is less likely to be inhibited, and the increase in the driving voltage is reduced. The thickness of the second semiconductor layer 12 for reducing the activation of the p-type impurity is, for example, 2.5 nm or less.

### Fourth Semiconductor Layer 14

The fourth semiconductor layer 14 is a semiconductor layer doped with a p-type impurity. The fourth semiconductor layer 14 is made of Alₓ₄In_{y4}Ga_{1-x4-y4}N (0 ≤ x4 ≤ 1, 0 ≤ y4 ≤ 1, 0 ≤ x4 + y4 ≤ 1), and a binary, ternary, or quaternary nitride semiconductors according to the composition x4 and y4 can be employed. The fourth semiconductor layer 14 is doped with, for example, Mg as the p-type impurity. The In composition ratio y4 of the fourth semiconductor layer 14 may be zero. In this case, the refractive index of the fourth semiconductor layer 14 decreases, and the light blocking performance can be enhanced.

The first semiconductor layer 11, the second semiconductor layer 12, the third semiconductor layer 13, and the fourth semiconductor layer 14 are processed into a shape of a ridge 16. In the cross section of FIG. 1, light is confined in the active layer 15 in the lateral direction due to the change in the refractive indices in the lateral direction by the ridge 16, that is, due to the change in the medium of the insulating film 19, Alₓ₄In_{y4}Ga_{1-x4-y4}N (0 ≤ x4 ≤ 1, 0 ≤ y4 ≤ 1, 0 ≤ x4 + y4 ≤ 1), and the insulating film 19. A p-side electrode 18 is provided on the upper surface of the ridge 16. A p-side contact layer may be provided at the interface between the fourth semiconductor layer 14 and the p-side electrode 18. The p-side contact layer contains the p-type impurity at a higher concentration than any layer of the fourth semiconductor layer 14. The first semiconductor layer 11 and the second semiconductor layer 12 are adjacent to each other. The second semiconductor layer 12 and the third semiconductor layer 13 are adjacent to each other. The third semiconductor layer 13 and the fourth semiconductor layer 14 are adjacent to each other. By making the layers continuous, the structure for reducing the increase in the operating voltage of the semiconductor laser element 10 can be accommodated in a narrow space.

### Distribution of Al Composition Ratio from First Semiconductor Layer to Fourth Semiconductor Layer

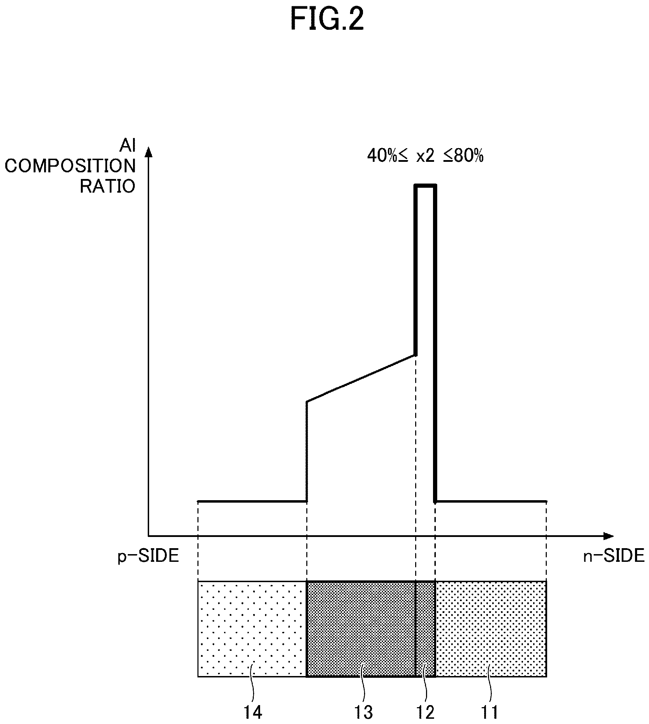

FIG. 2 illustrates the distribution of the Al composition ratio from the first semiconductor layer 11 to the fourth semiconductor layer 14 of the semiconductor laser element 10 according to the embodiment. The horizontal axis represents the position in the layering direction, in which the closer to the right, the closer to the n-side. The vertical axis represents the Al composition ratio. Among the first semiconductor layer 11 to the semiconductor layer 14, the second semiconductor layer 12 has the highest Al composition ratio x2. The Al composition ratio x2 is, for example, in a range from 0.4 to 0.8 (represented as "40% ≤ x2 ≤ 80%" in the drawing), and preferably from 0.45 to 0.75. Since the Al composition ratio x2 of the second semiconductor layer 12 is 0.4 or higher, the overflow of electrons can be efficiently blocked at the lower end of the conduction band. In general, the higher the Al composition ratio, the larger the band gap and the higher the electron blocking effect, but Al deactivates the p-type impurity. When the Al composition ratio x2 exceeds 0.8, the contact resistivity between the second semiconductor layer 12 and the active layer may increase due to deactivation of the p-type impurity, resulting in an increase in driving voltage. Therefore, the Al composition ratio x2 of the second semiconductor layer 12 is preferably in a range from 0.4 to 0.8.

The Al composition ratio x3 of the third semiconductor layer 13 is smaller than the Al composition ratio x2 of the second semiconductor layer 12. The Al composition ratio x3 of the third semiconductor layer 13 is greater than the Al composition ratio x1 of the first semiconductor layer 11 and the Al composition ratio x4 of the fourth semiconductor layer 14. The third semiconductor layer 13 is a composition gradient layer. The Al composition ratio x3 of the third semiconductor layer 13 gradually decreases from the side closer to the second semiconductor layer 12 toward the side closer to the fourth semiconductor layer 14, and sharply decreases at the boundary with the fourth semiconductor layer 14. The composition gradient of the third semiconductor layer 13 starts from the boundary between the second semiconductor layer 12 and the third semiconductor layer 13. This reduces the increase in operating voltage caused by the third semiconductor layer 13. An absolute value of the change rate of the Al composition ratios from the boundary between the third semiconductor layer 13 and the fourth semiconductor layer 14 toward the position where the Al composition ratio x4 indicates a minimum value in the fourth semiconductor layer 14 is greater than an absolute value of the change rate of the Al composition ratio in the third semiconductor layer 13. In other words, the Al composition ratio x3 gradually decreases in the third semiconductor layer 13 from the boundary with the second semiconductor layer 12 to the vicinity of the boundary with the fourth semiconductor layer 14, but sharply decreases at the boundary with the fourth semiconductor layer 14 to change the distribution of the Al composition ratio stepwise. This configuration can enhance the electron blocking effect in the third semiconductor layer 13.

The Al composition ratio in the region of the third semiconductor layer 13 closest to the second semiconductor layer 12 is 25% ± 5%. The Al composition ratio in the region of the third semiconductor layer 13 closest to the fourth semiconductor layer 14 is 18% ± 5% under the condition that the Al composition ratio is smaller than the Al composition ratio in the vicinity of the boundary with the second semiconductor layer 12. The Al composition ratio in the third semiconductor layer 13 at the point closest to the fourth semiconductor layer 14 is greater than the Al composition ratio x4 of the fourth semiconductor layer 14. This configuration can enhance the electron blocking effect in the third semiconductor layer 13. For example, when the thickness of the third semiconductor layer 13 is 10 nm, the Al composition ratio x3 gradually decreases over this range of thickness.

An absolute value of the change rate of the Al composition ratios x2 from the position where the Al composition ratio exhibits the maximum value in the second semiconductor layer 12 to the boundary between the second semiconductor layer 12 and the third semiconductor layer 13 is greater than an absolute value of the change rate of the Al composition ratios x3 of the third semiconductor layer 13. This configuration can enhance the electron blocking effect in the second semiconductor layer 12. In addition, an absolute value of the change rate of the Al composition ratio from the boundary between the first semiconductor layer 11 and the second semiconductor layer 12 to the position where the Al composition ratio exhibits the maximum value in the second semiconductor layer 12 is greater than the absolute value of the change rate of the Al composition ratios x3 of the third semiconductor layer. In other words, in the second semiconductor layer 12, the Al composition ratio x2 sharply increases in the vicinity of the boundary with the first semiconductor layer 11, and the Al composition ratio x2 sharply decreases in the vicinity of the boundary with the third semiconductor layer 13. This configuration can enhance the electron blocking effect in the second semiconductor layer 12. However, in terms of the change amount (absolute value) of the Al composition ratio, the change amount on the third semiconductor layer 13 side is smaller.

The Al composition ratio x4 of the fourth semiconductor layer 14 is in a range from 1% to 10%. This configuration can reduce optical loss due to Al. The fourth semiconductor layer 14 may be used as, for example, the p-side optical guide layer. The p-side optical guide layer has a lower refractive index and a larger band gap than the first semiconductor layer 11.

The Al composition ratio x1 of the first semiconductor layer 11 is in a range from 1% to 10% in the example illustrated in FIG. 2. This configuration can reduce optical loss due to Al. As mentioned above, when the first semiconductor layer 11 is made of Alₓ₁In_{y1}Ga_{1-x1-y1}N (0 ≤ x1 ≤ 1, 0 ≤ y1 ≤ 1, 0 ≤ x1 + y1 ≤ 1), a target oscillation wavelength can be designed by adjusting the Al composition ratio x1 and the In composition ratio y1. The Al composition ratio x1 of the first semiconductor layer 11 may be appropriately adjusted in a range from 1/50 to 1/5 of the peak Al composition ratio x2 of the second semiconductor layer 12.

The semiconductor laser element 10 has the distribution of Al composition ratios illustrated in FIG. 2, which suppresses the overflow of electrons from the first semiconductor layer 11 to the fourth semiconductor layer 14 and also prevents the injection of holes from the fourth semiconductor layer 14 into the first semiconductor layer 11, thereby improving the carrier injection efficiency. Improved carrier injection efficiency allows oscillation with less current, resulting in higher power output at the same injection current and improved power conversion efficiency.

The band gap energies of the first semiconductor layer 11, the second semiconductor layer 12, the third semiconductor layer 13, and the fourth semiconductor layer 14 may have the following relationships. That is, the band gap energy of the second semiconductor layer 12 is higher than the band gap energies of the first semiconductor layer 11, the third semiconductor layer 13, and the fourth semiconductor layer 14. The band gap energy of the third semiconductor layer 13 is higher than the band gap energies of the first semiconductor layer 11 and the fourth semiconductor layer 14. The band gap energy of the third semiconductor layer 13 gradually decreases from the side close to the second semiconductor layer 12 toward the side close to the fourth semiconductor layer 14.

### Fabricating and Evaluating Sample

A sample of the semiconductor laser element 10 was fabricated based on the distribution of the Al composition ratio illustrated in FIG. 2. An n-side semiconductor layer 3 having a thickness of 3 µm was formed on a GaN substrate. Ammonia, trimethylaluminum (TMA), trimethylgallium (TMG), and monosilane were used as source gases to grow silicon-doped AlGaN.

After the n-side semiconductor layer 3 was formed, the active layer 15 and the first semiconductor layer 11 were grown. The average Al composition ratio x1 of the first semiconductor layer 11 was 4.5%.

After the first semiconductor layer 11 was formed, the second semiconductor layer 12 was formed. The second semiconductor layer 12 could be used as a part of the electron blocking layer. Ammonia, TMA and TMG were used to form the second semiconductor layer 12 having the thickness of approximately 1.0 nm : Al_{0.5}Ga_{0.5}N.

Subsequently, the third semiconductor layer 13 was formed using ammonia, TMA, TMG, and biscyclopentadienyl magnesium (Cp₂Mg). The third semiconductor layer 13 was disposed closer to the p-side contact layer than the second semiconductor layer 12 and was able to be used as a part of the electron blocking layer. For example, the third semiconductor layer 13 having a thickness of 9.0 nm was made of Mg-doped AlGaN. The flow rate of TMA was gradually reduced after the start of introducing Cp₂Mg to adjust the thickness-direction distribution of the Al composition ratio x3 of the third semiconductor layer 13. The Al composition ratio immediately after the start of film formation of the third semiconductor layer 13, that is, the Al composition ratio in the vicinity of the boundary with the second semiconductor layer 12 was set to 25%. Thereafter, the flow rate of TMA was gradually decreased to set the Al composition ratio at the outermost surface of the third semiconductor layer 13 to 18%. Thus, the second semiconductor layer 12 and the third semiconductor layer 13 having the Al composition ratio distribution illustrated in FIG. 2 were formed.

Subsequently, ammonia, TMA, TMG, and Cp₂Mg were used to form the Mg-doped fourth semiconductor layer 14. The fourth semiconductor layer 14 was a p-side semiconductor layer close to the p-side contact layer, and included a p-side optical guide layer, a p-side cladding layer, a p-side contact layer, and the like. The average value of the Al composition ratio x4 of the fourth semiconductor layer 14 was, for example, 4.5%. Thus, a layered body including the first semiconductor layer 11 to the fourth semiconductor layer 14 was formed on the substrate 1.

In a predetermined region on the fourth semiconductor layer 14, an etching mask was formed to remove the fourth semiconductor layer 14 to the middle of the first semiconductor layer 11 by dry etching, and then the mask was removed to obtain the ridge shape illustrated in FIG. 1. An insulating film 19 was formed to cover the entire surface of the fourth semiconductor layer 14. The insulating film 19 on the upper surface of the ridge 16 was removed, and the p-side electrode 18 was formed on the upper surface of the fourth semiconductor layer 14. The p-side electrode 18 was made of a good conductor such as gold, platinum, titanium, or aluminum, or an alloy thereof. The p-side electrode 18 may be a transparent electrode made of ITO or the like depending on the application. The n-side electrode 17 was formed on the back surface of the substrate 1. The n-side electrode 17 was made of a good conductor such as gold, platinum, titanium, or aluminum, or an alloy thereof.

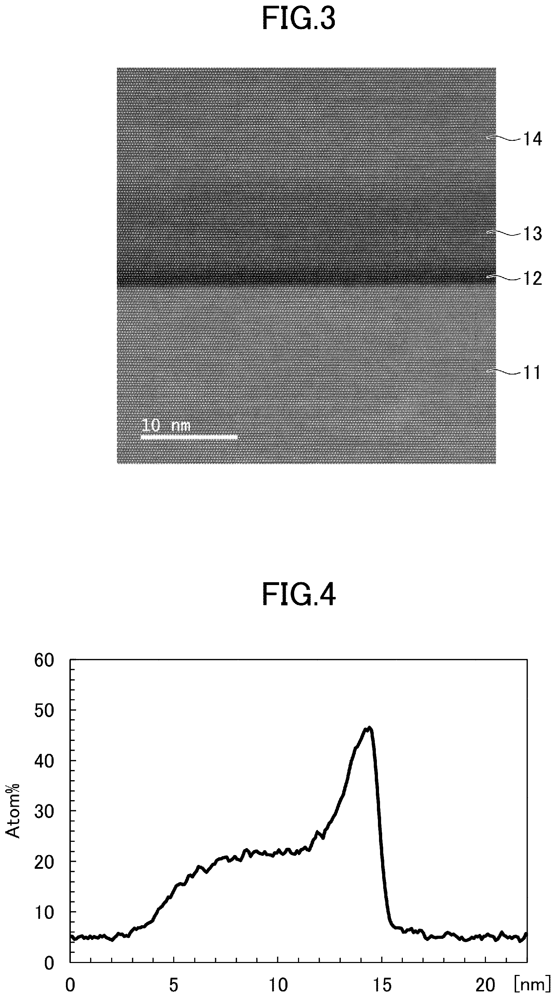

FIG. 3 illustrates a HAADF-STEM image of the fabricated sample. The vertical direction of the image in FIG. 3 coincides with the layering direction in FIG. 1. The lower side of FIG. 3 represents the first semiconductor layer 11, and the upper side represents the fourth semiconductor layer 14. The second semiconductor layer 12 having a high Al composition ratio can be seen between the third semiconductor layer 13 and the first semiconductor layer 11. The second semiconductor layer 12 may be used as a part of the electron blocking layer together with the third semiconductor layer 13.

FIG. 4 is a graph showing measured values of the Al composition ratio from the first semiconductor layer 11 to the fourth semiconductor layer 14. The horizontal axis represents the position [nm] in the depth direction from the fourth semiconductor layer 14 toward the first semiconductor layer 11 forming the ridge 16, and the vertical axis represents the Al composition ratio [atom%]. The Al composition ratio is measured by secondary ion mass spectrometry (SIMS). The left end (0 nm) of the horizontal axis is a position which is 5 nm into the fourth semiconductor layer 14 from the boundary between the third semiconductor layer 13 and the fourth semiconductor layer 14, and the right end (22 nm) is a position which is 7 nm into the first semiconductor layer 11 from the boundary between the first semiconductor layer 11 and the second semiconductor layer 12. The composition ratio in the depth direction is measured after sputtering with ion beams and repeating the mass analysis of secondary ions generated in the order of the fourth semiconductor layer 14, the third semiconductor layer 13, the second semiconductor layer 12, and the first semiconductor layer 11.

The Al composition ratio steeply changes from 50% to 4.5% at the interface between the second semiconductor layer 12 and the first semiconductor layer 11 located at positions in a range from 14 nm to 15 nm. The Al composition ratio changes discontinuously and steeply due to switching of the Al composition value between the first semiconductor layer 11 and the second semiconductor layer 12 during the sample fabrication process. The Al composition value changes from 50% to 25% at the interface between the second semiconductor layer 12 and the third semiconductor layer 13 located at positions in a range from 12 nm to 14 nm. The Al composition ratio also changes steeply due to switching of the Al composition value between the second semiconductor layer 12 and the third semiconductor layer 13 during the sample fabrication process. The Al composition ratio continuously changes from 18% to 25% in the third semiconductor layer 13 located at positions in a range from 5 nm to 12 nm. The Al composition ratio sharply changes from 18% to 4.5% at the interface between the third semiconductor layer 13 and the fourth semiconductor layer 14 at a position in the vicinity of the 5 nm. The Al composition ratio changes sharply due to the switching of the composition value of Al in forming the fourth semiconductor layer 14 on the third semiconductor layer 13 in the fabrication process of the sample. The Al composition ratio in FIG. 4 is continuously measured by the SIMS and may include a measurement error, and thus the distribution profile of the Al composition ratio may have a slope, but the measured values match well with the design values in FIG. 2.

As shown in FIGS. 3 and 4, by increasing the Al composition ratio of the second semiconductor layer 12 to the highest, the energy barrier at the lower end of the conduction band becomes high on the boundary side with the first semiconductor layer 11. From the measurement profile of the Al composition ratio in the layering direction in FIG. 4, it can be seen that the overflow of electrons to the fourth semiconductor layer 14 is effectively reduced. It is considered that this structure can block the electrons effectively and decrease the occurrence of carrier loss due to non-radiative recombination in the electron blocking layer.

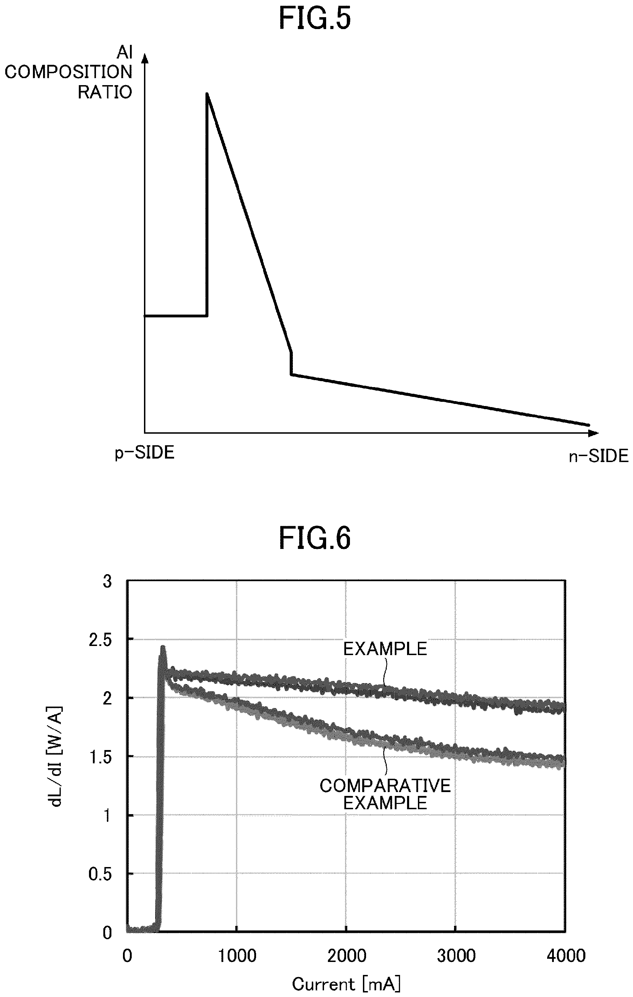

FIG. 5 is a graph showing, as a comparative example, a configuration example in which the peak of the Al composition ratio is present in a region close to the boundary between the electron blocking layer and the p-side semiconductor layer close to the p-side contact layer. In this graph, the n-side in the layering direction on the horizontal axis is the side closer to the active layer, and the p-side is the side closer to the p-side contact layer. The region having the peak of the Al composition ratio corresponds to the electron blocking layer. The electron blocking layer contains, for example, the p-type impurity such as Mg. In the layer of the first semiconductor layer closest to the electron blocking layer, the change in the Al composition ratio is discontinuous and rises to 2% at the boundary between the first semiconductor layer and the electron blocking layer.

In the electron blocking layer, the Al composition ratio transitions from 2% to 35% with increasing distance from the outermost surface of the first semiconductor layer 11. In the electron blocking layer in the comparative example, the peak of the Al composition ratio (35%) is located in the region of the electron blocking layer farthest from the active layer, and the Al composition ratio decreases sharply in the region further away from the active layer. In the comparative example, the Al composition ratio in the layer on the side farther from the active layer with reference to the position indicating the peak of the Al composition ratio is 4.5% as in the fourth semiconductor layer 14 of the embodiment.

In the comparative example of FIG. 5, the energy barrier at the lower end of the conduction band of the electron blocking layer having the peak of the Al composition ratio is formed in a region farthest from the active layer in the electron blocking layer, and decreases while inclining toward the active layer. It is considered that this structure makes electrons injected into the active layer undergo non-radiative recombination in the electron blocking layer before reaching the region having the peak of the Al composition ratio, causing the carrier loss.

FIG. 6 is a graph showing the slope efficiency of the semiconductor laser elements of the example and the comparative example. The horizontal axis represents an injection current [mA], and the vertical axis represents an increase ratio (dL/dI) of the optical output with respect to the current. The slope efficiency is the rate of increase in the optical output with respect to the injection current. The semiconductor laser element of the example maintains a substantially constant optical output even when the injection current increases. On the other hand, in the semiconductor laser element of the comparative example, the slope efficiency decreases in the high current region. This is because electrons injected into the active layer flow out to the p-side and do not contribute to generation of light.

The semiconductor laser element 10 according to the embodiment can improve the carrier injection efficiency by:
(a) making the thickness of the second semiconductor layer 12 less than the thickness of the third semiconductor layer 13;
(b) making the Al composition ratio x2 of the second semiconductor layer 12 greater than any of the Al composition ratio x1 of the first semiconductor layer 11, the Al composition ratio x3 of the third semiconductor layer 13, and the Al composition ratio x4 of the fourth semiconductor layer 14; and
(c) making the Al composition ratio x3 of the third semiconductor layer 13 greater than the Al composition ratio x1 of the first semiconductor layer and the Al composition ratio x4 of the fourth semiconductor layer.

The overflow of electrons to the p-side can be effectively blocked by making the absolute value of the change rate of the Al composition ratio from the first semiconductor layer 11 to the second semiconductor layer 12 greater than the absolute value of the change rate of the Al composition ratio in the third semiconductor layer 13.

The overflow of electrons to the p-side can be effectively blocked by making the absolute value of the change rate of the Al composition ratio from the second semiconductor layer 12 to the third semiconductor layer 13 greater than the absolute value of the change rate of the Al composition ratio in the third semiconductor layer 13.

The increase in the driving voltage can be reduced by setting the second semiconductor layer 12 to a range from 0.5 nm to 2.5 nm. The decrease in hole injection efficiency can be suppressed and the electrical conductivity can be improved by setting the Al composition ratios of the first semiconductor layer 11 and the fourth semiconductor layer 14 to a range from 1% to 10%.

For example, the following aspects are disclosed in addition to the above embodiments.

### Aspect 1

A light-emitting element comprising: a first semiconductor layer, a second semiconductor layer, a third semiconductor layer, and a fourth semiconductor layer in this order, wherein: the first semiconductor layer is Alx1Iny1Ga1-x1-y1N (0 ≤ x1 ≤ 1, 0 ≤ y1 ≤ 1, 0 ≤ x1 + y1 ≤ 1), the second semiconductor layer is Alx2Iny2Ga1-x2-y2N (0 ≤ x2 ≤ 1, 0 ≤ y2 ≤ 1, 0 ≤ x2 + y2 ≤ 1), the third semiconductor layer is Alx3Iny3Ga1-x3-y3N (0 ≤ x3 ≤ 1, 0 ≤ y3 ≤ 1, 0 ≤ x3 + y3 ≤ 1), and the fourth semiconductor layer is Alx4Iny4Ga1-x4-y4N (0 ≤ x4 ≤ 1, 0 ≤ y4 ≤ 1, 0 ≤ x4 + y4 ≤ 1), the second semiconductor layer and the third semiconductor layer contain a p-type impurity, a thickness of the second semiconductor layer is less than a thickness of the third semiconductor layer, an Al composition ratio x2 of the second semiconductor layer is greater than any of an Al composition ratio x1 of the first semiconductor layer, an Al composition ratio x3 of the third semiconductor layer, and an Al composition ratio x4 of the fourth semiconductor layer, and the Al composition ratio x3 of the third semiconductor layer is greater than the Al composition ratio x1 of the first semiconductor layer and the Al composition ratio x4 of the fourth semiconductor layer.

### Aspect 2

The light-emitting element according to Aspect 1, wherein: the Al composition ratio x3 of the third semiconductor layer decreases from the second semiconductor layer to the fourth semiconductor layer, and an absolute value of a change rate of the Al composition ratio from a boundary between the third semiconductor layer and the fourth semiconductor layer to a position at which the Al composition ratio exhibits a minimum value in the fourth semiconductor layer is greater than an absolute value of a change rate of the Al composition ratio x3 of the third semiconductor layer.

### Aspect 3

The light-emitting element according to Aspect 1 or 2, wherein: an absolute value of a change rate of the Al composition ratio from a boundary between the first semiconductor layer and the second semiconductor layer to a position at which the Al composition ratio exhibits a maximum value in the second semiconductor layer is greater than an absolute value of a change rate of the Al composition ratio x3 of the third semiconductor layer.

### Aspect 4

The light-emitting element according to any one of Aspect 1 to 3, wherein: an absolute value of a change rate of the Al composition ratio from a position at which the Al composition ratio exhibits a maximum value in the second semiconductor layer to a boundary between the second semiconductor layer and the third semiconductor layer is greater than an absolute value of a change rate of the Al composition ratio x3 of the third semiconductor layer.

### Aspect 5

The light-emitting element according to any one of Aspect 1 to 4, wherein: the thickness of the second semiconductor layer is greater than 0.5 nm and 2.5 nm or less.

### Aspect 6

The light-emitting element according to any one of Aspect 1 to 5, wherein: a total thickness of the second semiconductor layer and the third semiconductor layer is greater than 5 nm and 30 nm or less.

### Aspect 7

The light-emitting element according to any one of Aspect 1 to 6, wherein: the Al composition ratio x2 of the second semiconductor layer is in a range from 40% to 80%.

### Aspect 8

The light-emitting element according to any one of Aspect 1 to 7, wherein: the Al composition ratio x1 of the first semiconductor layer is in a range from 1% to 10%.

### Aspect 9

The light-emitting element according to any one of Aspect 1 to 8, wherein: the Al composition ratio x4 of the fourth semiconductor layer is in a range from 1% to 10%.

### Aspect 10

The light-emitting element according to any one of Aspect 1 to 9, wherein: the fourth semiconductor layer contains an impurity of a first conductivity type, and an amount of the impurity of the first conductivity type in the third semiconductor layer is smaller than an amount of the impurity of the first conductivity type in the fourth semiconductor layer.

### Reference Signs List

1 Substrate
3 n-side semiconductor layer
10 Semiconductor laser element
11 First semiconductor layer
12 Second semiconductor layer
13 Third semiconductor layer
14 Fourth semiconductor layer
15 Active layer
17 n-side electrode
18 p-side electrode
x1 Al composition ratio of first semiconductor layer
x2 Al composition ratio of second semiconductor layer
x3 Al composition ratio of third semiconductor layer
x4 Al composition ratio of fourth semiconductor layer

## Claims

1. A light-emitting element comprising:
a first semiconductor layer, a second semiconductor layer, a third semiconductor layer, and a fourth semiconductor layer in this order, wherein:
the first semiconductor layer is Alₓ₁In_{y1}Ga_{1-x1-y1}N (0 ≤ x1 ≤ 1, 0 ≤ y1 ≤ 1, 0 ≤ x1 + y1 ≤ 1), the second semiconductor layer is Alₓ₂In_{y2}Ga_{1-x2-y2}N (0 ≤ x2 ≤ 1, 0 ≤ y2 ≤ 1, 0 ≤ x2 + y2 ≤ 1), the third semiconductor layer is Al_{X3}In_{y3}Ga_{1-x3-y3}N (0 ≤ x3 ≤ 1, 0 ≤ y3 ≤ 1, 0 ≤ x3 + y3 ≤ 1), and the fourth semiconductor layer is Alₓ₄In_{y4}Ga_{1-x4-y4}N (0 ≤ x4 ≤ 1, 0 ≤ y4 ≤ 1, 0 ≤ x4 + y4 ≤ 1),
the second semiconductor layer and the third semiconductor layer contain a p-type impurity,
a thickness of the second semiconductor layer is less than a thickness of the third semiconductor layer,
an Al composition ratio x2 of the second semiconductor layer is greater than any of an Al composition ratio x1 of the first semiconductor layer, an Al composition ratio x3 of the third semiconductor layer, and an Al composition ratio x4 of the fourth semiconductor layer, and
the Al composition ratio x3 of the third semiconductor layer is greater than the Al composition ratio x1 of the first semiconductor layer and the Al composition ratio x4 of the fourth semiconductor layer.

2. The light-emitting element according to claim 1, wherein:
the Al composition ratio x3 of the third semiconductor layer decreases from the second semiconductor layer to the fourth semiconductor layer, and
an absolute value of a change rate of the Al composition ratio from a boundary between the third semiconductor layer and the fourth semiconductor layer to a position at which the Al composition ratio exhibits a minimum value in the fourth semiconductor layer is greater than an absolute value of a change rate of the Al composition ratio x3 of the third semiconductor layer.

3. The light-emitting element according to any of the preceding claims, wherein:
an absolute value of a change rate of the Al composition ratio from a boundary between the first semiconductor layer and the second semiconductor layer to a position at which the Al composition ratio exhibits a maximum value in the second semiconductor layer is greater than an absolute value of a change rate of the Al composition ratio x3 of the third semiconductor layer.

4. The light-emitting element according to any of the preceding claims, wherein:
an absolute value of a change rate of the Al composition ratio from a position at which the Al composition ratio exhibits a maximum value in the second semiconductor layer to a boundary between the second semiconductor layer and the third semiconductor layer is greater than an absolute value of a change rate of the Al composition ratio x3 of the third semiconductor layer.

5. The light-emitting element of any of the preceding claims, wherein:
the thickness of the second semiconductor layer is greater than 0.5 nm and 2.5 nm or less.

6. The light-emitting element according to any of the preceding claims, wherein:
a total thickness of the second semiconductor layer and the third semiconductor layer is greater than 5 nm and 30 nm or less.

7. The light-emitting element according to any of the preceding claims, wherein:
the Al composition ratio x2 of the second semiconductor layer is in a range from 40% to 80%.

8. The light-emitting element according to any of the preceding claims, wherein:
the Al composition ratio x1 of the first semiconductor layer is in a range from 1% to 10%.

9. The light-emitting element according to any of the preceding claims, wherein:
the Al composition ratio x4 of the fourth semiconductor layer is in a range from 1% to 10%.

10. The light-emitting element according to any of the preceding claims, wherein:
the fourth semiconductor layer contains an impurity of a first conductivity type, and
an amount of the impurity of the first conductivity type in the third semiconductor layer is smaller than an amount of the impurity of the first conductivity type in the fourth semiconductor layer.
